Europäisches Patentamt

(19) European Patent Office

Office européen des brevets

(11) Numéro de publication: **0 197 825**
**A1**

(12) # DEMANDE DE BREVET EUROPEEN

(21) Numéro de dépôt: 86400579.8

(22) Date de dépôt: 19.03.86

(51) Int. Cl.⁴: **G 01 R 19/17**

(30) Priorité: 25.03.85 FR 8504403

(43) Date de publication de la demande:
15.10.86 Bulletin 86/42

(84) Etats contractants désignés:
BE DE GB IT

(71) Demandeur: COMMISSARIAT A L'ENERGIE ATOMIQUE
Etablissement de Caractère Scientifique Technique et
Industriel
31/33, rue de la Fédération
F-75015 Paris(FR)

(72) Inventeur: Lepetit, Jean Louis
5 Impasse Maurice Chevalier
F-21800 Chevigny Saint Sauveur(FR)

(72) Inventeur: Lepagnot, Jean Pierre
Cité de la Douix
F-21440 Saint Seine L'Abbaye(FR)

(72) Inventeur: Poussier, Emile
6, rue Foch
F-21120 Is-Sur-Tille(FR)

(74) Mandataire: Mongrédien, André et al,
c/o BREVATOME 25, rue de Ponthieu
F-75008 Paris(FR)

(54) Circuit d'analyse en temps réel de la distribution énergétique des impulsions d'un signal d'impulsions.

(57) Circuit d'analyse en temps réel de la distribution par
fenêtre énergétique des impulsions d'un signal d'impulsions.

Il comprend un convertisseur analoguique-numérique
(2) recevant le signal d'impulsion et délivrant, pour chaque
impulsion, un premier code représentatif de l'amplitude de
ladite impulsion, ledit premier code pouvant prendre N
valeurs, un ensemble de n échelles de comptage ($6_1$, $6_2$, . . .,
$6_n$), où n N, correspondant chacun à une fenêtre énergétique,
et un moyen de codage (4) recevant ledit premier code et
délivrant un second code pur adresser l'une des échelles de
comptage, ledit second code pouvant prendre au moins n
valeurs, le contenu de l'échelle adressée étant incrémenté,
ledit moyen de codage (4) comprenant une mémoire (12) et
un décodeur binaire (14), ladite mémoire comprenant N
cellules de mémorisation et recevant le premier code sur son
entrée d'adresse, ledit décodeur binaire étant relié en entrée
à la sortie de donnée de la mémoire et délivrant le second
code.

FIG. 1

EP 0 197 825 A1

## CIRCUIT D'ANALYSE EN TEMPS REEL DE LA DISTRIBUTION ENERGETIQUE DES IMPULSIONS D'UN SIGNAL D'IMPULSIONS

La présente invention a pour objet un circuit d'analyse en temps réel de la distribution énergétique des impulsions d'un signal d'impulsions. Dans ce circuit, la distribution énergétique des impulsions est définie par le comptage du nombre d'impulsions tombant dans des fenêtres énergétiques, ou des bandes énergétiques, prédéterminées. Ce circuit permet notamment l'analyse de la distribution énergétique de phénomènes physiques non stationnaires, tels que la désintégration radioactive d'un corps radioactif.

On sait que la masse d'un corps radioactif contenu dans un matériau constitué de plusieurs éléments peut être déterminée par le taux de désintégration de ce corps. Le rayonnement, corpusculaire ou électromagnétique, associé à cette désintégration a une énergie parfaitement définie. Chaque désintégration étant convertie en une impulsion, le comptage des impulsions tombant dans une fenêtre énergétique centrée sur ladite énergie de désintégration permet d'évaluer le taux de désintégration de ce corps. Notons que si le matériau comporte plusieurs corps radioactifs, la masse de chacun de ceux-ci peut être déterminée si les fenêtres énergétiques associées à ces corps radioactifs sont disjointes.

Le taux de comptage dans chaque fenêtre énergétique résulte de la superposition des désintégrations du corps radioactif et du bruit de fond dû au rayonnement cosmique et au terrain où la mesure est réalisée. Ce bruit de fond est évalué par le comptage des impulsions tombant dans une fenêtre énergétique indépendante des autres fenêtres énergétiques et dans laquelle aucune désintégration due à un corps radioac-

B 8581.3 BL

tif analysé n'est possible. Le taux de désintégration réel de chaque corps radioactif analysé est ainsi déterminé par le taux de comptage dans la fenêtre énergétique associé diminué du taux de comptage dû au bruit de fond.

Les circuits connus d'analyse de la distribution énergétique des impulsions d'un signal d'impulsions comprennent un convertisseur analogique-numérique délivrant un code numérique représentatif de l'amplitude de l'impulsion reçue, un moyen de mémorisation comprenant autant de cellules de mémorisation que de valeurs possibles du code numérique, et des moyens de traitement pour incrémenter le contenu de la cellule de mémorisation associée au code numérique délivré par le convertisseur analogique-numérique.

Lorsque le comptage est terminé, les informations contenues dans chaque cellule de mémorisation sont représentatives de la distribution énergétique du phénomène mesuré. Cette distribution énergétique est définie par le nombre d'impulsions par canal, ou niveau d'énergie.

Si l'on désire connaître la distribution énergétique des impulsions du signal mesuré par fenêtres énergétiques, il faut additionner les nombres contenus dans tous les canaux correspondant à une même fenêtre énergétique. Ce traitement ne peut avoir lieu qu'après la fin de l'analyse du signal mesuré. Ceci occasionne ainsi un temps mort non négligeable entre deux analyses consécutives.

Le but principal de l'invention est de supprimer ce temps mort de façon que la distribution énergétique du signal d'impulsions par fenêtres énergétiques soit disponible immédiatement après la fin de l'analyse du signal mesuré.

Pour atteindre ce but, l'invention prévoit

B 8581.3  BL

un ensemble de n échelles de comptage correspondant chacune à une fenêtre énergétique, le contenu d'une échelle de comptage étant incrémenté lorsque l'amplitude de l'impulsion reçue est comprise dans la bande énergétique de la fenêtre associée. De cette manière, la distribution énergétique par fenêtre d'énergie est réalisée en temps réel.

De manière plus précise, le circuit d'analyse en temps réel de l'amplitude des impulsions d'un signal d'impulsions dans des fenêtres énergétiques est caractérisé en ce qu'il comprend :

- un convertisseur analogique-numérique recevant ledit signal d'impulsions et délivrant, pour chaque impulsion, un premier code représentatif de l'amplitude de ladite impulsion, ledit premier code pouvant prendre N valeurs,

- un ensemble de n échelles de comptage où n  N, correspondant chacune à une fenêtre énergétique, et

- un moyen de codage recevant ledit premier code et délivrant un second code pour adresser l'une des échelles de comptage, ledit second code pouvant prendre au moins n valeurs, le contenu de l'échelle de comptage adressée étant incrémenté, ledit moyen de codage comprenant une mémoire et un décodeur binaire, ladite mémoire comprenant N cellules de mémorisation et recevant le premier code sur son entrée d'adresse, ledit décodeur binaire étant relié en entrée à la sortie de donnée de la mémoire et délivrant le second code.

Dans ce circuit, le contenu d'une échelle de comptage est incrémenté lorsque le premier code représentant l'amplitude d'une impulsion est compris entre deux valeurs déterminées représentant respectivement la borne inférieure et la borne supérieure de la fenêtre énergétique. En général, une échelle de comptage est associée à chaque fenêtre énergétique. Toutefois, on peut également associer plusieurs fenêtres énergétiques différentes à une seule échelle de comptage.

De manière préférée, une valeur au moins du second code est associée aux énergies extérieures aux fenêtres énergétiques définies.

Ceci présente l'avantage que la somme des valeurs contenues dans les échelles de comptage est alors égale au nombre d'impulsions reçues. Ceci est utile pour étudier la statistique de l'énergie des impulsions du signal mesuré.

La mémoire utilisée peut notamment être une mémoire vive ou une mémoire morte, programmable ou reprogrammable.

Les caractéristiques et avantages de l'invention ressortiront mieux de la description qui va suivre, donnée à titre illustratif mais non limitatif, en référence aux dessins annexés, sur lesquels :

- la figure 1 représente schématiquement le circuit d'analyse de l'invention,

- la figure 2 illustre la correspondance entre l'amplitude d'un signal, les fenêtres énergétiques et les échelles de comptage associées, et

- la figure 3 représente de manière détaillée le moyen de codage du circuit de l'invention.

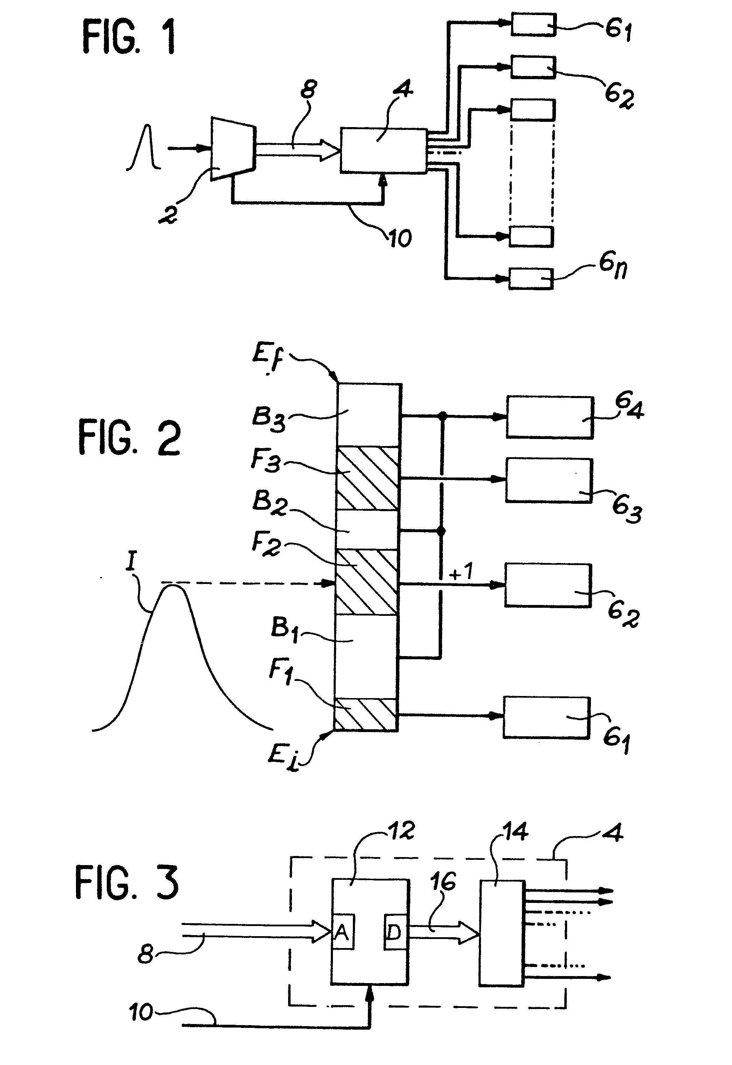

La figure 1 représente schématiquement le circuit d'analyse de l'invention. Ce circuit comprend un convertisseur analogique-numérique 2, un moyen de codage 4 et un ensemble d'échelles de comptage $6_1$, $6_2$, ..., $6_n$. Le convertisseur analogique-numérique 2 reçoit le signal d'impulsions. Il délivre sur une voie de donnée 8 un premier code numérique représentatif de l'amplitude d'une impulsion reçue et sur une voie de commande 10 un signal de synchronisation.

Le premier code numérique peut avantageusement être un ensemble de signaux binaires, par exemple un octet pouvant représenter 256 niveaux d'amplitude. Le signal de synchronisation émis sur la voie 10 permet la réception du code émis sur la voie 8 par le moyen de codage 4.

En fonction de la valeur de ce premier code, le moyen de codage 4 commande l'incrémentation du contenu de l'une des échelles de comptage $6_1$, $6_2$, ... $6_n$.

Toutes les échelles de comptage, sauf éventuellement une échelle de comptage, sont associées à une fenêtre d'énergie et sont incrémentées lorsque l'énergie de l'impulsion reçue par le convertisseur analogique-numérique 2 est comprise entre le seuil inférieur et le seuil supérieur de la bande énergétique associée à ladite échelle de comptage.

Une échelle de comptage déterminée peut représenter les énergies extérieures aux bandes d'énergie associées aux autres échelles de comptage. Cette dernière échelle de comptage est ainsi incrémentée lorsque l'intensité de l'impulsion reçue ne correspond pas à une des fenêtres énergétiques définies. L'utilisation de cette échelle de comptage présente l'avantage que la somme des valeurs contenues dans toutes les échelles de comptage est alors égale à la somme des impulsions reçues par le circuit. Ceci est indispensable pour une étude statistique précise de la distribution énergétique des impulsions du signal reçu.

La figure 2 illustre la correspondance entre l'intensité d'une impulsion, les fenêtres énergétiques définies et les échelles de comptage. On note $E_i$ et $E_f$ les énergies inférieure et supérieure de la bande d'énergie traitée par le circuit d'analyse. A titre d'exemple, on a défini dans cette bande trois fenêtres énergétiques disjointes $F_1$, $F_2$ et $F_3$. Ce découpage fait apparaître dans la bande $[E_i, E_f]$ trois bandes $B_1$, $B_2$ et $B_3$.

B 8581.3  BL

6

Le circuit d'analyse est doté de quatre échelles de comptage $6_1$, $6_2$, $6_3$ et $6_4$. Les trois premières échelles de comptage sont associées respectivement aux trois fenêtres énergétiques $F_1$, $F_2$ et $F_3$ ; la quatrième échelle de comptage est associée aux bandes $B_1$, $B_2$ et $B_3$.

On a représenté sur la figure 2 une impulsion I dont l'amplitude est comprise entre les énergies $E_i$ et $E_f$. Plus précisément, l'amplitude de cette impulsion est comprise entre les bornes de la fenêtre énergétique $F_2$. Dans cette situation, le moyen de codage du circuit de l'invention commande l'incrémentation de l'échelle de comptage $6_2$ associée à cette fenêtre $F_2$.

On a représenté de manière détaillée sur la figure 3 le moyen de codage du circuit de l'invention. Il comprend une mémoire 12 et un décodeur binaire 14. L'entrée d'adresse de la mémoire 12 est reliée à la voie 8, sa sortie de donnée est reliée par une voie 16 à l'entrée du décodeur binaire 14. La sélection de la mémoire 12 est réalisée par le signal émis sur la voie 10.

Le décodeur binaire 14 comporte p entrées et $n=2^p$ sorties. Chaque sortie est reliée à une échelle de comptage.

La mémoire 12 comporte au moins N cellules de mémorisation qui sont chacune associée à une intensité donnée de l'impulsion reçue. Toutes les cellules correspondant à une fenêtre énergétique déterminée contiennent la même valeur. Celle-ci transmise par la voie 16 au décodeur binaire 14, permet d'activer la sortie du décodeur binaire associée à l'échelle de comptage qui correspond à cette fenêtre énergétique. Ainsi, le contenu de l'échelle de comptage est incrémenté.

Le demandeur a réalisé un circuit d'analyse conforme aux figures 1 et 3. Le convertisseur analogique-numérique 2 est de type ADC 820, la mémoire 12 de type 6166L-5, le décodeur binaire de type HEF 4514 et les échelles de comptage sont constituées par des circuits 82C54 contenant chacun trois échelles de comptage. Dans ce circuit, le premier code délivré sur la voie 8, est un octet et le second code, délivré sur la voie 16, comporte 4 éléments binaires.

Outre les éléments représentés sur les figures 1 et 3, le circuit d'analyse de l'invention comprend, de manière classique, des moyens de séquencement des signaux entre les différents éléments du circuit. Il peut également comprendre avantageusement un processeur notamment lorsque la mémoire est une mémoire vive (RAM) ou une mémoire morte reprogrammable (EPROM ou EEPROM).

REVENDICATIONS

1. Circuit d'analyse en temps réel de l'amplitude des impulsions d'un signal d'impulsions dans des fenêtres énergétiques caractérisé en ce qu'il comprend :

- un convertisseur analogique-numérique (2) recevant ledit signal d'impulsions et délivrant, pour chaque impulsion, un premier code représentatif de l'amplitude de ladite impulsion, ledit premier code pouvant prendre N valeurs,

- un ensemble de n échelles de comptage ($6_1$, $6_2$, ..., $6_n$) où n N, correspondant chacune à une fenêtre énergétique, et

- un moyen de codage (4) recevant ledit premier code et délivrant un second code pour adresser l'une des échelles de comptage, ledit second code pouvant prendre au moins n valeurs, le contenu de l'échelle de comptage adressée étant incrémenté, ledit moyen de codage (4) comprenant une mémoire (12) et un décodeur binaire (14), ladite mémoire comprenant N cellules de mémorisation et recevant le premier code sur son entrée d'adresse, ledit décodeur binaire étant relié en entrée à la sortie de donnée de la mémoire et délivrant le second code.

2. Circuit selon la revendication 1, caractérisé en ce que les fenêtres énergétiques sont disjointes, une valeur du second code au moins étant associée aux énergies inter-fenêtres.

3. Circuit selon la revendication 2, caractérisé en ce que la mémoire (12) est une mémoire vive.

4. Circuit selon la revendication 2, caractérisé en ce que la mémoire (12) est une mémoire morte programmable.

1/1                                    0197825

FIG. 1

FIG. 2

FIG. 3

**0197825**

Numero de la demande

EP 86 40 0579

Office européen
des brevets

**RAPPORT DE RECHERCHE EUROPEENNE**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int Cl.4) |
|---|---|---|---|
| Y | NUCLEAR INSTRUMENTS & METHODS, vol. 121, no. 3, 1974, pages 567-572, North-Holland Publishing Co., Amsterdam, NL; G.E. O'BRIEN et al.: "A digital gate unit for two-parameter multichannel analysis" * Page 567, figure 1; page 569, paragraphe 2.2, figure 3; page 570, paragraphe 2.3 * | 1,2 | G 01 R 19/17 |
| Y | IEEE TRANSACTONS ON NUCLEAR SCIENCE, vol. NS-16, no. 5, octobre 1969, pages 36-57, New York, US; B. SOUCEK: "State of art in multichannel pulse data analysis" * Page 39, figure 4; page 41, figure 6; page 47, paragraphe 7, figure 13; pages 52-53, paragraphe 10; figure 23 * | 1,2 | |
| Y | IEEE TRANSACTIONS ON BIOMEDICAL ENGINEERING, vol. BME-26, no. 7, juillet 1979, pages 436-440, IEEE, New York, US; S.J. RACKHAM et al.: "A pulse height analyzer for displaying coulter counter particle size distributions" * Page 437, figure 1; page 438, figures 2-3 * | 1,2 | |
| A | IDEM | 3 | |

DOMAINES TECHNIQUES RECHERCHES (Int. Cl.4)

G 01 R

--- -/-

Le présent rapport de recherche a été établi pour toutes les revendications

| Lieu de la recherche LA HAYE | Date d'achèvement de la recherche 13-06-1986 | Examinateur KAUFFMANN J. |
|---|---|---|

Office européen des brevets

**RAPPORT DE RECHERCHE EUROPEENNE**

| **DOCUMENTS CONSIDERES COMME PERTINENTS** | | | Page 2 |
|---|---|---|---|
| Catégorie | Citation du document avec indication, en cas de besoin, des parties pertinentes | Revendication concernée | CLASSEMENT DE LA DEMANDE (Int. Cl 4) |
| A | RADIO FERNSEHEN ELEKTRONIK, vol. 27, no. 9, septembre 1978, pages 583-586, Berlin, DD; D. LANGE: "Digitales Datenklassifiziergerät zur Aufnahme empirischer Verteilungen" <br><br> ----- | | |
| | | | **DOMAINES TECHNIQUES RECHERCHES (Int Cl.4)** |

Le présent rapport de recherche a été établi pour toutes les revendications

| Lieu de la recherche | Date d'achèvement de la recherche | Examinateur |
|---|---|---|
| LA HAYE | 13-06-1986 | KAUFFMANN J. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82